# EUROPEAN PATENT APPLICATION

(11) **EP 4 597 578 A1**
(43) Date of publication of application: **06.08.2025**
(21) Application number: 24186408.1
(22) Date of filing: 04.07.2024
(51) Int. Cl.: H01L 29/778, H01L 29/423, H01L 29/40, H01L 29/10, H01L 29/20

(54) **DEVICE WITH INNER AND OUTER SPACERS**

(30) Priority: 30.01.2024 US 202418427063
(71) Applicant: GlobalFoundries U.S. Inc., Malta, NY 12020 (US)
(72) Inventor: HEBERT, Francois, Santa Clara, CA 95054 (US); SUSAI, Lawrence Selvaraj, Essex Junction, VT 05452 (US); BENTLEY, Steven John, Malta, NY 12020 (US)
(74) Representative: Lambacher, Michael

(57) **Abstract**

A semiconductor structure and, more particularly, a device with inner (22) and outer (23) spacer structures and methods of manufacture is disclosed. The structure includes: a gate structure (14) on a semiconductor substrate (12); a gate metal (16) connecting to the gate structure; inner sidewall spacers (22) contacting and surrounding the gate metal; a passivation layer (20) on the inner sidewall spacers; and outer sidewall spacers (23) on the passivation layer and adjacent to sides of the gate structure.

## Description

### BACKGROUND

This invention was made with government support under Contract # HQ0727790700 awarded by the Defense Microelectronics Activity (DMEA). The government has certain rights in the invention.

The present disclosure relates to semiconductor structures and, more particularly, to a device with inner and outer spacer structures and methods of manufacture.

A high-electron-mobility transistor (HEMT) is a field-effect transistor incorporating a junction between two materials with different band gaps (i.e. a heterojunction) as the channel, instead of a doped region (as is generally the case for a MOSFET). Commonly used material families are GaN or GaAs, although other materials can be used, dependent on the application of the device.

Due to the higher critical field and switching figures of merit of the GaN materials system, GaN HEMT devices typically have a higher electric-field strength than silicon MOSFETS, providing substantial performance improvements in, for example, on-resistance and breakdown voltage, while offering fast switching speed, amongst other important parameters. Since these properties result in fundamentally higher system efficiency, HEMTs may be used in diverse power management applications, such as AC-DC and DC-DC conversion in the consumer or automotive space. In RF applications, they may be used in high frequency power amplifiers, low noise amplifiers or switches in such applications as cell phones, satellite or receivers or radar equipment.

### SUMMARY

In an aspect of the disclosure, a structure comprises: a gate structure on a semiconductor substrate; a gate metal connecting to the gate structure; inner sidewall spacers contacting and surrounding the gate metal; a passivation layer on the inner sidewall spacers; and outer sidewall spacers on the passivation layer and adjacent to sides of the gate structure. Additional features of the structure are set forth in dependent claims 2 to 8.

In an aspect of the disclosure, a structure comprises: a device over a wide-bandgap semiconductor layer; a passivation layer on the device; a gate metal connecting to the device; inner sidewall spacers on the passivation layer and surrounding the gate metal; a liner over the inner sidewall spacers; and outer sidewall spacers on the liner and surrounding the device. Additional features of the structure are set forth in dependent claims 10 to 14.

In an aspect of the disclosure, a method comprises: forming a gate structure on a semiconductor substrate; forming a gate metal connecting to the gate structure; inner sidewall spacers contacting and surrounding the gate metal; forming a passivation layer on the inner sidewall spacers; and forming outer sidewall spacers on the passivation layer and adjacent to sides of the gate structure.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a structure and respective fabrication processes in accordance with aspects of the present disclosure.
FIG. 2 shows a structure in accordance with additional aspects of the present disclosure.
FIG. 3 shows a structure in accordance with further aspects of the present disclosure.
FIG. 4 shows a structure in accordance with yet additional aspects of the present disclosure.
FIGS. 5A-5D show fabrication processes for manufacturing the structure of FIG. 1 in accordance with aspects of the present disclosure.

### DETAILED DESCRIPTION

The present disclosure relates to semiconductor structures and, more particularly, to a device with inner and outer spacer structures and methods of manufacture. More specifically, the device may be an enhancement mode (e.g., off) high-electron-mobility transistor (HEMT) with inner and outer dielectric spacers surrounding the gate structure. Advantageously, the devices may be scalable short channel enhancement mode devices, necessary for high performance lower voltage GaN power technologies. In embodiments, for example, the devices can be scalable to very short lengths to minimize channel resistance, particularly when operating voltage is reduced. In addition, the methods described herein may reduce stress on the edges of the p-GaN gate structure (e.g., during formation of a gate metal process).

In more specific embodiments, the HEMT may be a p-GaN HEMT with a self-aligned spacer-based structure for a p-GaN gate structure, e.g., gate electrode, of the e-mode GaN HEMT device. In embodiments, the self-aligned approach is based on the use of inner and outer spacers, with a gate metal precisely aligned to the gate structure without causing stress or shorts. The outer spacers may be used to protect the gate structure and a passivation layer, e.g., formed by atomic layer deposition (ALD) during metal gate deposition processes. The outer spacers are also independent of the interlevel dielectric material outside of the gate structure region which increases design flexibility. In embodiments, both the outer spacer and the inner spacer may comprise insulator material.

The structures of the present disclosure can be manufactured in a number of ways using a number of different tools. In general, though, the methodologies and tools are used to form structures with dimensions in the micrometer and nanometer scale. The methodologies, i.e., technologies, employed to manufacture the structures of the present disclosure have been adopted from integrated circuit (IC) technology. For example, the structures are built on wafers and are realized in films of material patterned by photolithographic processes on the top of a wafer. In particular, the fabrication of the structures uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

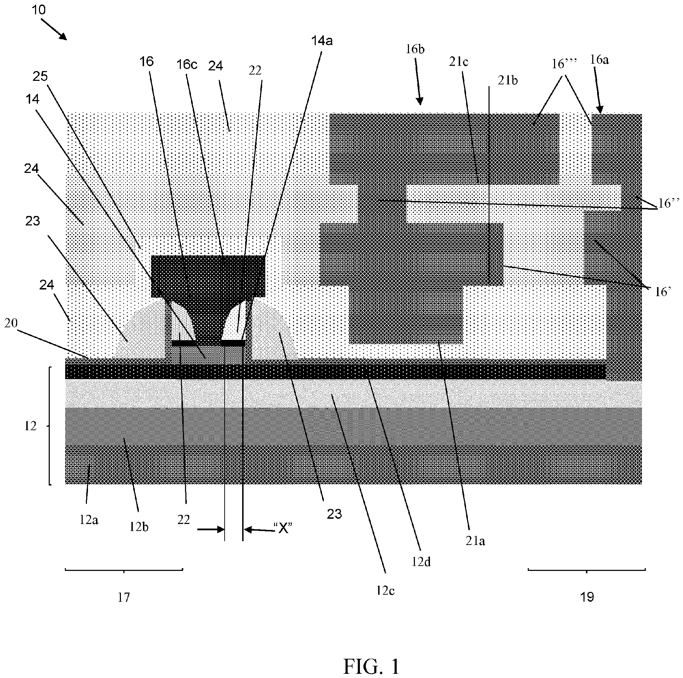

FIG. 1 shows a structure and respective fabrication processes in accordance with aspects of the present disclosure. More specifically, the structure 10 of FIG. 1 may be a p-GaN gate structure 14 with a gate metal 16 surrounded by inner dielectric spacers 22 and outer dielectric spacers 23. A passivation layer 20 may be provided between the inner dielectric spacers 22 and the outer dielectric spacers 23. In embodiments, the outer dielectric spacers 23 will protect the p-GaN gate structure 14 during subsequent fabrication processes, e.g., forming field plates and depositing of gate metal, in addition to reducing process variations and the electric field when a voltage is applied to a drain side 19 of the device. For example, the outer dielectric spacers 23 allow for a tight control of the spacing of the field plates.

More specifically, the structure 10 includes a semiconductor substrate 12. The semiconductor substrate 12 may comprise a semiconductor 12a comprising Si; although other suitable materials are contemplated herein including, but not limited to, SiGe, SiGeC, SiC, GaN, AlN, GaAs, InAs, InP, and other III/V or II/VI compound semiconductors, or may be an engineered substrate with multiple layers, such as silicon-on-insulator (SOI). In preferred embodiments, the semiconductor material substrate may comprise a suitable crystal orientation, e.g., <111> in the case of silicon.

The remaining semiconductor materials 12b-12d may be a stack of semiconductor materials used to form an AlGaN HEMT device. By way of illustrative and non-limiting example, a wide-bandgap semiconductor layer 12b may be formed on the semiconductor substrate 12a. The wide-bandgap semiconductor layer 12b may be, for example, an AlGaN stack of materials as is known in the art. For example, and as a non-limiting illustrative example, the wide-bandgap semiconductor layer 12b may comprise, in a layered stack of semiconductor materials, a seed layer, e.g., AlN, on the underlying semiconductor substrate 12a, with a buffer layer (e.g., AlGaN/GaN superlattices) and a channel layer 12c, e.g., GaN. In embodiments, the channel layer 12c may be undoped GaN formed over the wide-bandgap semiconductor layer 12b, with a barrier layer 12d, which may be AlGaN formed over the undoped GaN. In other embodiments, the layer 12d may be AlN, InAlN, InGaN, GaN or multiple materials. The stack of semiconductor materials may be formed by conventional epitaxial growth processes or other known deposition methods, e.g., metal-organic chemical vapor deposition (MOCVD) or molecular beam epitaxy (MBE).

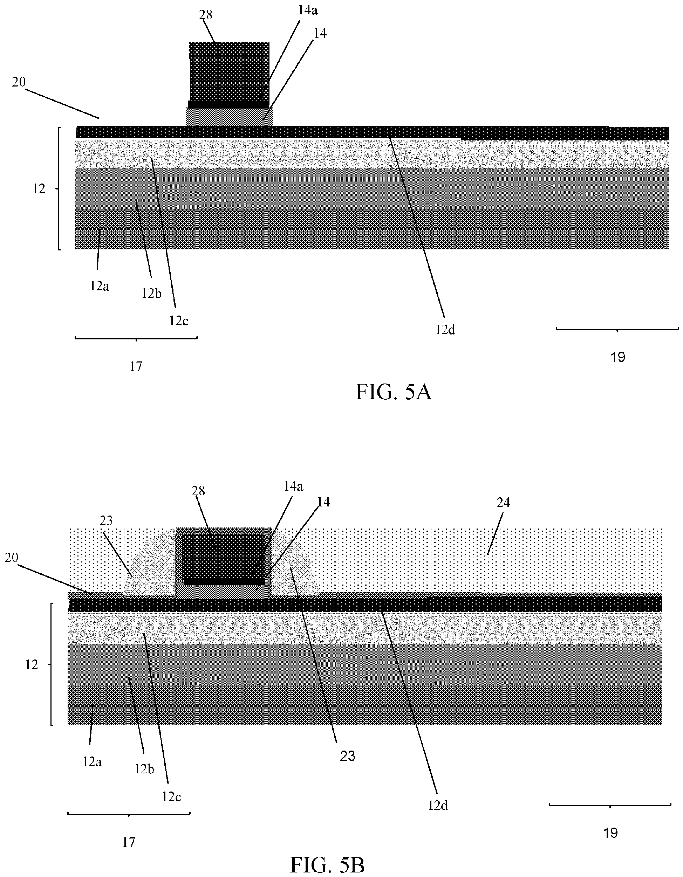

A p-doped GaN layer may be formed over the barrier layer 12d, and then patterned to form the p-GaN gate structure 14. An optional N-type, undoped thin GaN layer or SiN material may be provided on the surface of the p-GaN gate structure 14 as shown at reference numeral 14a. This additional passivation layer 14a acts as an etch stop as described with respect to FIGS. 5A-5D. The passivation layer 14a may be formed by any conventional deposition method, e.g., CVD or ALD or deposited in-situ during the MOCVD epitaxial growth, and patterned with the gate material using conventional lithography and etching processes as known in the art such that no further explanation is required for a complete understanding of the present disclosure.

Still referring to FIG. 1, the device 10 (e.g., including p-GaN gate structure 14) may comprise the channel layer 12c and barrier layer 12d. For example, the device 10 may include a source region 17 and a drain region 19 (e.g., active regions) of the channel layer 12c and/or barrier layer 12d. The semiconductor material may be epitaxially grown with an in-situ doping, e.g., p-type doping such as magnesium (Mg), as is known in the art.

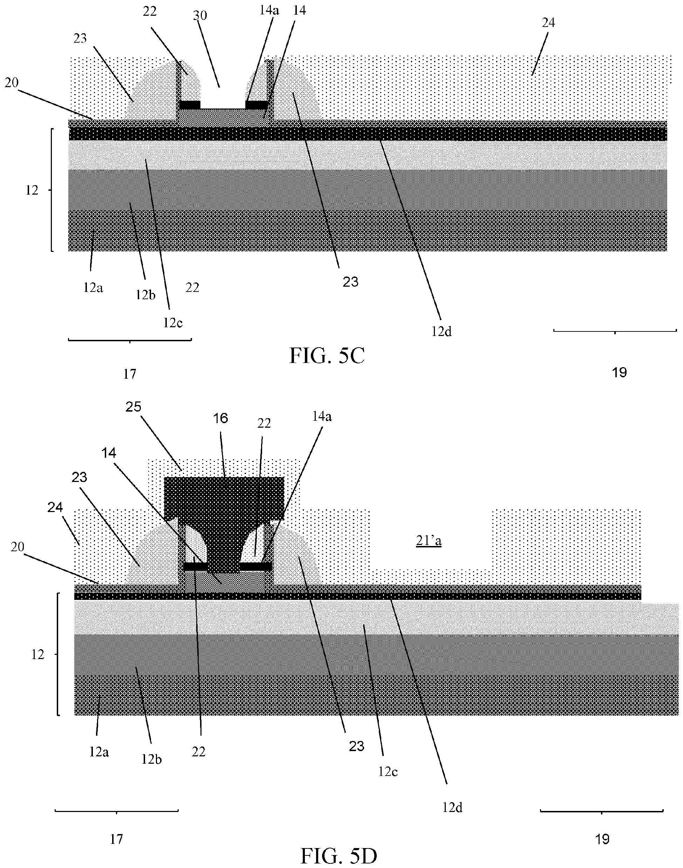

A gate metal 16, e.g., TiN, TiAl and/or TaN, may be provided on top of and in contact with the semiconductor material of the device 10, e.g., p-GaN gate structure 14. In embodiments, the gate metal 16 may be deposited by conventional deposition methods (e.g., CVD, PVD, ALD and other techniques), followed by conventional lithography and etching (e.g., reactive ion etching (RIE)) processes as is known in the art prior to the deposition of interlevel dielectric material 24 as shown in FIGS. 5C and 5D. The gate metal 16 may be a refractory metal or its compound, e.g., titanium (Ti), titanium nitride (TiN), tantalum (Ta), tantalum nitride (TaN), palladium (Pd), tungsten (W), or tungsten silicide (WSi₂).

FIG. 1 further shows metal material 16a, 16b. The metal material 16a, 16b includes an upper metal layer 16‴ (e.g., power metal at a first metal layer), an ohmic contact 16' and a via 16" connecting the upper metal layer 16‴ to the ohmic contact 16'. The metal material 16a, 16b may be the same or different metal material as the gate metal 16. For example, the metal material 16a, 16b may be aluminum (Al). In embodiments, the metal material 16a, 16b may be deposited after patterning, e.g., lithography and etching processes, of the interlevel dielectric material as shown in FIG. 5D. The ohmic contact 16' of the metal material 16a may connect to the drain region 19, e.g., channel layer 12c; whereas the ohmic contact 16' of the metal contact 16b embedded within interlevel dielectric material 24 may be used as field plates 21a, 21b, 21c at different wiring levels, connecting to the source 17.

Although the metal field plates 21a, 21b, 21c may be formed from the metal material of the metal material 16b, it is also contemplated that the metal field plates 21a, 21b, 21c may be separate wiring layers which connect to the metal material 16b. For example, in an optional embodiment, a metal wiring (e.g., TiN) on a first level may be used as a field plate 21a, connecting to the metal material 16b. Also, it should be understood that the thickness of the interlevel dielectric material 24 between the field plates 21a, 21b, 21c and the passivation layer 20 may be used to reduce the electric field on the gate structure 14 due to depletion of the electric field on the drain side 19.

It should further be recognized that the outer dielectric spacers 23 may be used to protect the gate structure 14 (e.g., p-GaN gate structure) during fabrication processes, e.g., etching processes to form the field plates, in additional to reducing stresses during the formation of the gate metal 16. For example, the outer dielectric spacers 23 will protect the passivation layer 20 during an etching process to form the ohmic contact 16b and respective field plates. In addition, the outer dielectric spacers 23 will reduce stress on the gate structure 14 which otherwise results from different coefficients of expansion between the ohmic contacts and gate metal (e.g., expansion and contraction of the metal gate during the fabrication processes) and the material of the gate structure 14, while also reducing process variability.

In embodiments, the passivation layer 20 may be, for example, silicon nitride, silicon oxide, aluminum oxide or multiple materials, and may be deposited using atomic layer deposition (ALD), CVD, or any other known deposition methods. The passivation layer 20 may be located on an outer sidewall of the inner dielectric spacers 22 and over the semiconductor substrate 12, including at edges and a side of the active device 14, e.g., p-GaN gate structure. The outer dielectric spacers 23 may be formed on the passivation layer 20, opposing the inner dielectric spacers 22 and extending to over the side and corners of the p-GaN gate structure 14. The outer dielectric spacers 23 and the inner dielectric spacers 22 may be a dielectric material such as nitride, oxide or oxynitride as examples, and may be a different material than the passivation layers 14a, 20. In the latter configuration, a selective etch process can be performed to form the outer dielectric spacers 23 without attacking (e.g., etching) the passivation layer 20.

Still referring to FIG. 1, the inner dielectric spacers 22 and the outer dielectric spacers 23 may be a single layer of a dielectric insulator material, e.g., oxide or nitride or oxynitride, or multiple layers of insulator material. In embodiments, the inner dielectric spacers 22 will be above the active device 10, e.g., p-GaN gate structure 14, and will surround outer edges of the gate metal 16. For example, the inner dielectric spacers 22 may be above the passivation layer 14a on the p-GaN gate structure 14 and, more specifically, the inner dielectric spacers 22 will be encapsulated between the passivation layers 14a, 20 (on an outer sidewall), the pGaN gate structure 14 (on the bottom surface of the dielectric spacers 22); whereas the outer dielectric spacers 23 may be provided on the passivation layer 20 at a corner and sides of the gate structure 14. Interlevel dielectric material 24 may be formed over the outer dielectric spacers 23 and interlevel dielectric material 25 may be formed over the gate metal 16. (Hereinafter, each of the different layers of interlevel dielectric material will be denoted with reference numeral 24 and/or 25, even though such layers of material may be deposited at different times.)

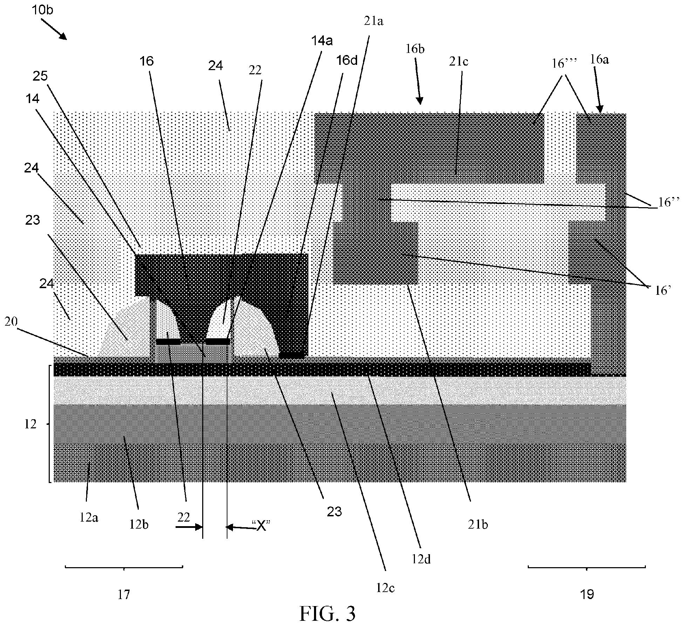

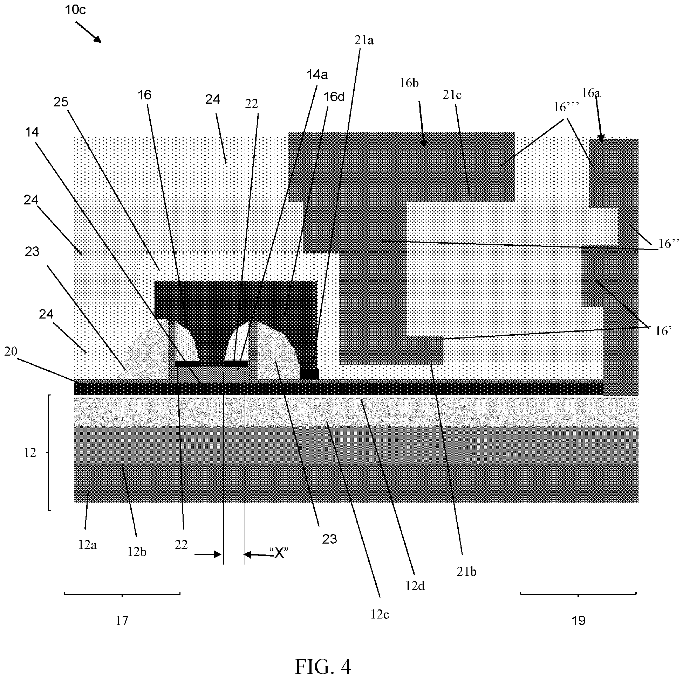

As further shown in FIG. 1, the gate metal 16 provided on the p-GaN gate structure 14 may be self-aligned and surrounded by the inner dielectric spacers 22 and the outer dielectric spacers 23. Also, in embodiments, the inner dielectric spacers 22, the outer dielectric spacers 23 and passivation layer 20 will have a same or similar height, below a horizontal portion 16c of the gate metal 16. In further embodiments, the gate metal 16 may be symmetrically positioned over the active device 14 and surrounded by the inner dielectric spacers 22 and the outer dielectric spacers 23. By way of example, the gate metal 16 may be symmetrically offset by a distance "X" from edges of the p-GaN gate structure 14, where the offset distance "X" is a thickness of the inner dielectric spacers 22. Moreover, the profile of the gate metal 16 will follow the profile of the inner dielectric spacers 22 and, in some embodiments (e.g., FIGS. 3 and 4) the profile of the outer dielectric spacers 23.

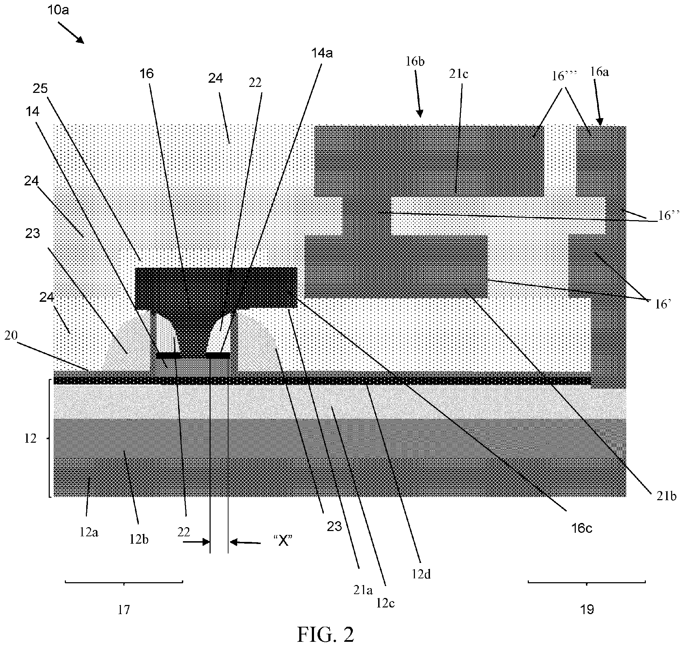

FIG. 2 shows a structure in accordance with additional aspects of the present disclosure. In the structure 10a of FIG. 2, the gate metal 16 will have a horizontal portion 16c that overhangs over and, in embodiments, beyond the outer dielectric spacers 23 on the drain side 19. In this configuration, the field plate 21a may be connected to the gate metal 16, which has a lower voltage potential than the drain itself. Also, in this configuration, the outer dielectric spacers 23 may be used to further protect the gate structure 14 during formation of the first field plate 21a (e.g., etching and deposition processes). In embodiments, the field plate 21a should not be connected to the source side 17, and the outer dielectric spacer 23 on the source side 17 may be eliminated. The remaining features are similar to the structure 10 of FIG. 1.

FIG. 3 shows another structure in accordance with additional aspects of the present disclosure. In the structure 10b of FIG. 3, the gate metal 16 may have a portion 16d that wraps around and conforms to the shape of the outer dielectric spacer 23 on the drain side 19. In this structural configuration, a portion 16d of the gate metal 16 may connect to the field plate 21a abutting the outer dielectric spacer 23. The gate metal 16 connecting to the field plate may be used for applications in which gate to drain capacitance is less important.

The field plate 21a may be formed on the passivation layer 20 below any portion of the gate metal 16 (and substantially on a same level as the p-GaN gate structure 14). In this way, as in the embodiment of FIG. 2, the field plate 21a may be connected to the gate metal 16, which has a lower voltage potential than the drain 19. Also, in this configuration, the field plate 21a may be self-aligned due to the width and position of the outer dielectric spacer 23. Moreover, in this embodiment, the outer dielectric spacer 23 on the source side 17 may be eliminated. The remaining features are similar to the device 10 of FIG. 1.

FIG. 4 shows yet another structure in accordance with additional aspects of the present disclosure. Much like the structure 10b, in the structure 10c of FIG. 4, the gate metal 16 may have a portion 16d that wraps around and conforms to a shape of the outer dielectric spacer 23 on the drain side 19. Also, the portion 16d may contact the self-aligned first field plate 21a formed on the passivation layer 20. In this way, as in the embodiment of FIG. 3, the field plate 21a may be connected to the gate metal 16, which has a lower voltage potential than the drain 19. In this embodiment, the field plate 21b may be closer to the semiconductor substrate 12, e.g., have a thinner interlevel dielectric material 24 between the field plate 21b and the passivation layer 20. Also, similar to the structure 10c of FIG. 3, the outer dielectric spacer 23 on the source side 17 may be eliminated. Moreover, interlevel dielectric material 25 may be formed, e.g., deposited, over the gate metal 16. This additional interlevel dielectric material 25 may be formed under the field plate 21b. The remaining features are similar to the structure 10b of FIG. 3.

FIGS. 5A-5D show respective fabrication processes for manufacturing the structure of FIG. 1 in accordance with aspects of the present disclosure. It should be understood by those of skill in the art that similar fabrication processes may be used to manufacture the structures of FIGS. 2-4, with modifications to the patterning processes for the gate metal and field plates as should be understood by those of skill in the art.

As shown in FIG. 5A, the p-GaN gate structure 14 can be formed on the semiconductor substrate 12, e.g., patterned, using a hardmask 28. In embodiments, the hardmask 28 can be a nitride material or other hardmask material as is known in the art. For example, the p-GaN gate structure 14 may be formed by deposition of the p-GaN material on the substrate 12, followed by the deposition of a passivation layer 14a (etch stop) and the hardmask 28. The p-GaN material, passivation layer 14a and hardmask 28 can be patterned using conventional lithography and etching processes, e.g., reactive ion etching (RIE) or atomic layer etching (ALE) or a combination of etches, as is known in the art.

The conventional lithography and etching processes include forming a resist over the hardmask material, which is exposed to energy (light) and developed by utilizing a conventional resist developer to form a pattern (opening). An etching process with a selective chemistry, e.g., reactive ion etching (RIE) or atomic layer etching (ALE), will be used to transfer the pattern into the hardmask material and the P-GaN material to form the gate structure 14. The resist may be removed by a conventional oxygen ashing process or other known stripants.

FIG. 5B shows the formation of the outer dielectric spacers 23. To form the outer dielectric spacers 23, the passivation layer 20 is formed over the patterned gate structure 14 and hardmask 28. In embodiments, the passivation layer 20 may be a nitride material, an oxide material, or may be comprised of multiple materials formed by ALD or CVD processes. An optional oxide material may be deposited on the passivation layer 20, depending on the desired thickness for a particular field plate design.

The outer dielectric spacers 23 are formed by a conformal deposition of insulator material over the passivation layer 20, followed by an anisotropic etching process to form the outer dielectric spacers 23. For example, on ore more layers of a low-k dielectric material may be deposited on the structure using, for example, a CVD or ALD process. The low-k dielectric material can be etched by an anisotropic etching process to form the outer dielectric spacers 23. An interlevel dielectric material 24 may be deposited over the outer dielectric spacers 23 and hardmask 28, followed by a conventional planarization process, e.g., chemical mechanical polishing (CMP). The CMP process will stop on the passivation layer 20, over the hardmask 28.

In FIG. 5C, inner dielectric spacers 22 are formed on sidewalls of the trench 30. For example, the passivation layer 20 over the hardmask and the hardmask, itself, may be selectively removed to form a trench 30, which exposes the underlying passivation layer 14a over the p-GaN gate structure 14. In embodiments, the passivation layer 14a will act as an etch stop layer to protect the p-GaN gate structure 14. As should be understood by those of skill in the art, the trench 30 will have sidewalls comprising the passivation layer 20.

The inner dielectric spacers 22 are formed on sidewalls of the trench 30 and, more specifically, over the passivation layers 14a, 20 within the trench 30. The spacer material may be, for example, oxide, nitride, oxynitride or other low-k dielectric materials. In embodiments, the inner dielectric spacers 22 may be formed by a conventional blanket deposition process, e.g., CVD, followed by an etch back process, e.g., anisotropic etching process, to remove the spacer material from a top surface of passivation layer 14a over the p-GaN gate structure 14. The spacer material will also be removed from the top surface of the interlevel dielectric material 24. In this way, the inner dielectric spacers 22 are self-aligned to the edges of the p-GaN gate structure 14. Following the formation of the inner dielectric spacers 22, the exposed portions of the passivation layer 14a can be removed by a selective etching process to expose the underlying p-GaN gate structure 14.

FIG. 5D shows the fabrication processes for FIG. 1. As shown in FIG. 5D, the gate metal 16 may be formed by deposition and patterning processes. In embodiments, the outer dielectric spacers 23 will reduce stress on the gate structure when fabricating the gate metal, which can result due to different coefficients of expansion of the metal materials compared to the gate structure, etc., while also providing a self-aligning mechanism for the formation of at least bottom field plate 21.

By way of example, metal material may be blanket deposited (e.g., PVD or CVD) within the trench, formed in contact with the underlying p-GaN gate structure 14. The metal material will also be deposited over the inner dielectric spacers 22 and outer dielectric spacers 23. The metal material can then be patterned to form any of the different configurations shown in FIGS. 1-4. It should be recognized, though, that in the embodiments of FIGS. 2-4, a deposition of and interlevel dielectric material 25 over the gate metal 16 and other regions and patterning process will result in the formation of a trench 21'a used to form the field plate 21a, prior to the metal material being deposited. As should be understood, the gate metal 16 will be self-aligned to the p-GaN gate structure 14, and will also be offset from the edges of the p-GaN gate structure 14 by the inner dielectric spacers 22.

An alternative embodiment for forming the recessed region 21'a for the field plate structure, is to apply a mask after the gate metal 16 is formed. This field plate recess can stop selectively over the passivation layer 20. Once the selective etch is completed and the photoresist is removed from the wafer, the dielectric layer 25 can be deposited to insulate the gate metal 16, and to form the dielectric thickness in the field plate recess 21'a.

The process flow continues with conventional back end of the line (BEOL) processes as described with respect to FIG. 1, with the outer dielectric spacers 23 protecting the p-GaN gate structure 14 during additional fabrication process of, for example, the field plates and the ohmic contacts. By way of example, additional interlevel dielectric material 25 may be deposited over the gate metal 16, followed by a patterning process to form the different patterns within the interlevel dielectric material 24 and 25, which conform to the shape of the metal material 16a, 16b as shown in FIGS. 1-4. The metal material and field plates on the drain side 19 can be deposited within the patterned interlevel dielectric material 24 and 25. This same process can be repeated for each different field plate at different levels of the device as should be understood by those of skill in the art.

The HEMT can be utilized as a single device in discrete applications, may be combined in a single package with several other devices of the same or varying types via co-packaging or multi-chip 3D integration techniques, or may be combined with several other devices in system on chip (SoC) technology. The SoC is an integrated circuit (also known as a "chip") that integrates all components of an electronic system on a single chip or substrate. As the components are integrated on a single substrate, SoCs consume much less power and take up much less area than multi-chip designs with equivalent functionality. Because of this, SoCs are becoming the dominant force in the mobile computing (such as in Smartphones) and edge computing markets. SoC is also used in embedded systems and the Internet of Things. Moreover, GaN devices are increasingly being employed in SoC designs where multiple GaN HEMTs are formed on a single substrate.

The method(s) as described above is used in the fabrication of discrete devices or integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes discrete devices or integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a gate structure on a semiconductor substrate;
a gate metal connecting to the gate structure;
inner sidewall spacers contacting and surrounding the gate metal;
a passivation layer on the inner sidewall spacers; and
outer sidewall spacers on the passivation layer and adjacent to sides of the gate structure.

2. The structure of claim 1, wherein the gate structure comprises p-GaN material.

3. The structure of claim 1 or claim 2, wherein the inner sidewall spacers and the outer sidewall spacers comprise dielectric material, and/or wherein the passivation layer is a nitride material between the inner sidewall spacers and the outer sidewall spacers.

4. The structure of one of claims 1 to 3, wherein the outer sidewall spacers surround the gate structure and the gate metal and the inner sidewall spacers are above the gate structure.

5. The structure of one of claims 1 to 4, wherein the gate metal extends over an outside of the outer sidewall spacers on a drain side.

6. The structure of claim 5, further comprising a field plate connecting to the gate metal on the outside the outer sidewall spacers on the drain side, and, optionally, wherein the field plate abuts the outer sidewall spacers on the drain side.

7. The structure of claim 6, further comprising a second field plate connecting to an ohmic contact at a level different than the field plate connecting to the gate metal, and, optionally, wherein the second field plate connects to a source.

8. The structure of one of claims 1 to 6, further comprising a field plate connecting to the gate metal above the outer sidewall spacers on a drain side.

9. A structure, comprising:
a device over a wide-bandgap semiconductor layer;
a passivation layer on the device;
a gate metal connecting to the device;
inner sidewall spacers on the passivation layer and surrounding the gate metal;
a liner over the inner sidewall spacers; and
outer sidewall spacers on the liner and surrounding the device.

10. The structure of claim 9, wherein the device comprises a p-GaN gate structure.

11. The structure of claim 9 or claim 10, wherein the outer sidewall spacers surround the gate metal, and/or wherein the gate metal extends over an outer side of the outer sidewall spacers on a drain side and extends to liner.

12. The structure of claim 11, further comprising a field plate connecting to the gate metal, and, optionally, wherein the field plate abuts the outer sidewall spacers and connects to the gate metal.

13. The structure of claim 12, further comprising a second field plate remote from the outer sidewall spacers and connecting to a source of the device.

14. The structure of one of claims 9 to 13, wherein the inner sidewall spacers are on an inner portion of the passivation layer, the outer sidewall spacers are on an outer portion of the passivation layer, and the gate metal is surrounded by the inner sidewall spacers, the passivation layer and the outer sidewall spacers.

15. A method comprising:
forming a gate structure on a semiconductor substrate;
forming a gate metal connecting to the gate structure;
forming inner sidewall spacers contacting and surrounding the gate metal;
forming a passivation layer on the inner sidewall spacers; and
forming outer sidewall spacers on the passivation layer adjacent to sides of the gate structure.
